# EUROPEAN PATENT APPLICATION

(11) **EP 4 787 073 A1**
(43) Date of publication of application: **05.08.2026**
(21) Application number: 25155237.8
(22) Date of filing: 31.01.2025
(51) Int. Cl.: G03F 7/00, G01B 11/22, G01N 21/956

(54) **APPARATUS AND METHOD FOR QUANTIFYING A LATERAL ETCH DEPTH**

(71) Applicant: ASML Netherlands B.V., 5500 AH Veldhoven (NL)
(72) Inventor: ÖZTÜRK, Fahri Emre, 5500 AH Veldhoven (NL); HINTERDING, Stijn, Oskar, Matisse, 5500 AH Veldhoven (NL); TARABRIN, Sergey, 5500 AH Veldhoven (NL); NAYAK, Deepak, Ranjan, 5500 AH Veldhoven (NL)
(74) Representative: ASML Netherlands B.V.

(57) **Abstract**

Methods, targets, and apparatus for measuring an etch depth of a structure on a substrate. A substrate is provided, comprising the structure and a etch-sensitive target configured to have an asymmetric response to a etch. An etch of the substrate is performed, thereby affecting an asymmetry in the etch-sensitive target. The etch-sensitive target is measured, using radiation, to quantify the asymmetry, and the quantified asymmetry is mapped to the etch depth based on predetermined etch reference values.

## Description

### FIELD

The present invention relates to methods and apparatus for measuring an etch depth of a structure on a patterned substrate. In particular it relates to measuring an etch sensitive target for determining a lateral etch depth.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

As the size of structures is scaled down, design changes are required. Small-scale structures may comprise vertically stacked structures, such as gate-all-around (GAA), nanosheet, forksheet, and complementary field effect transistor (CFET) devices, which may require recess etching in a fabrication process. Different strategies may be employed to measure such designs. Current technologies for measuring an extend of etch recess include transmission electron microscopy (TEM), scanning electron microscopy (SEM), Critical Dimension Small Angle X-Ray Scatterometry (CDSAXS), etc. However, several challenges exist with these technologies, such as slow speed, destructive effects on the metrology target, or their implementation in a high volume manufacturing environment. Provided herein are improved methods and systems for measuring and quantifying an extent of a recess etch, that address at least some of the challenges with existing metrology methods.

### SUMMARY

According to an aspect of the current disclosure there is provided a method for measuring an etch depth of a structure on a substrate. The method comprises providing the substrate comprising the structure and a etch-sensitive target configured to have an asymmetric response to a etch. An etch of the substrate is performed, thereby affecting an asymmetry in the etch-sensitive target. The method further comprises measuring, using radiation, the etch-sensitive target to quantify the asymmetry, and mapping the quantified asymmetry to the etch depth based on predetermined etch reference values.

Optionally, the etch-sensitive target may be patterned in a single layer in the substrate.

Optionally, the etch may be a lateral etch, and the etch-sensitive target may be a lateral-etch sensitive target.

Optionally, the measuring may comprise measuring radiation diffracted by the asymmetric etch-sensitive target.

Optionally, measuring the etch-sensitive target to quantify the asymmetry may comprise determining an intensity difference between a positive first diffraction order and negative first diffraction order.

Optionally, the measuring may be performed in an exit pupil plane of a metrology tool, or in an image plane of a metrology tool.

Optionally, the wavelength of the radiation may comprise one or more wavelengths in a range of 100 nm - 2000 nm, or one or more wavelengths in a range of 300 nm to 900 nm.

Optionally, the target may comprise a subsegmented diffraction arrangement comprising a plurality of diffraction elements, wherein each diffraction element may be segmented into a plurality of proxy structures.

Optionally, the diffraction arrangement may be a diffraction grating, and the plurality of diffraction elements may comprise a plurality of grating lines.

Optionally, at least some of the plurality of proxy structures may comprise alternating horizontal layers in a device layer of the substrate.

Optionally, at least some of the plurality of proxy structures may comprise one or more of a nanosheet structure, a forksheet structure, or a gate all around structure.

Optionally, at least some of the plurality of proxy structures may comprise a DRAM structure, or a 3DNAND structure.

Optionally, at least some of the plurality of proxy structures may comprise an asymmetric etch sensitivity.

Optionally, each proxy structure of the plurality of proxy structures may comprise the same asymmetric etch sensitivity.

Optionally, one or more of the plurality of proxy structures may comprise an asymmetric etch sensitivity, and the other of the plurality of proxy structures are insensitive to an etch.

Optionally, the measuring may comprise using soft-X-ray radiation to obtain etch depth information.

Optionally, the measuring may comprise obtaining etch depth information for one or more individual layers on the substrate.

Optionally, the target may be patterned in two vertically stacked layers.

Optionally, the etch may be a lateral etch, and the etch-sensitive target may be a lateral-etch sensitive target.

Optionally, the measuring may comprise obtaining an overlay measurement of radiation diffracted by the target.

Optionally, the wavelength of the radiation may comprise one or more wavelengths in a range of 100 nm - 2000 nm.

Optionally, a first layer of the two vertically stacked layers of the target may comprise a plurality of proxy structures configured to introduce an asymmetry as a function of the amount of etch.

Optionally, each proxy structure of the first layer may comprise the same asymmetry introducing proxy structure.

Optionally, one or more of the plurality of proxy structures may comprise an asymmetry introducing proxy structure, and the others of the plurality of proxy structures may comprise a structure, such as a dummy structure, that is insensitive to an etch.

Optionally, the etch reference values may have been determined using a reference measurement method.

Optionally, the reference measurement method may be one of: a Transmission Electron Microscopy TEM measurement, a Scanning Electron Microscopy SEM measurement, a Soft X-Ray SXR measurement, a Critical Dimension Small Angle X-Ray Scattering measurement CDSAXS, or X-Ray Fluorescence XRF measurement.

Optionally, the etch reference values may have been determined by repeating a referencing measurement process for each of the plurality of etch reference values. The determining may include, for each etch amount of a plurality of etch amounts: measuring, using the reference measurement method, the etch depth on a reference structure for the etch amount, and adding the measured etch depth as an etch reference value; measuring the asymmetry of a reference etch-sensitive target for the etch amount; and associating the measured asymmetry to the etch reference value.

Optionally, the etch sensitive target and the structure may comprise silicon germanium SiGe configured to be at least partially removed during the etch.

Optionally, the etch-sensitive target and the structure may comprise one or more of an oxide of silicon SiOₓ, a nitride of silicon SiₓN_{y}, or a silicon oxynitride SiₓO_{y}N_{z}, configured to be at least partially removed during the etch.

According to another aspect of the current disclosure there is provided a target on a substrate for measurement of a etch depth of a structure on a substrate. The target comprises a first layer on the substrate comprising a subsegmented diffraction arrangement comprising a plurality of diffraction elements. Each diffraction element comprises a plurality of proxy structures. One or more of the plurality of proxy structures comprise an asymmetrical etch sensitivity.

Optionally, the target may be patterned in a single layer of the substrate.

Optionally, the target may comprise a second layer on the substrate, and the measurement of the etch depth of the structure may be an overlay measurement.

According to another aspect of the current disclosure there is provided an apparatus configured to perform a method as described above.

According to another aspect of the current disclosure there is provided an exposure apparatus for a semiconductor manufacturing process configured to perform a method as described above.

According to another aspect of the current disclosure there is provided a metrology apparatus configured to perform a method as described above.

According to another aspect of the current disclosure there is provided an inspection apparatus configured to perform a method as described above.

According to another aspect of the current disclosure there is provided a lithography apparatus configured to perform a method as described above.

According to another aspect of the current disclosure there is provided a litho cell comprising an apparatus as described above.

According to another aspect of the current disclosure there is provided a substrate comprising a target as described above.

According to another aspect of the current disclosure there is provided an apparatus comprising a processor to perform the method of any of claims 1 to 14.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 7 depicts a flow chart with steps of a method for measuring an etch depth of a structure on a substrate;
- Figures 8(a), (b), and (c) depict schematic representations of example structures having a symmetrical (a) or asymmetrical (b), (c) sensitivity to a lateral etch;
- Figure 9 depicts a schematic representation of an example etch sensitive target comprising a subsegmentation into a plurality of nanosheet structures;
- Figure 10 depicts a schematic representation of an example etch sensitive target comprising a subsegmentation into a plurality of asymmetric forksheet structures;
- Figure 11 depicts a schematic representation of an example etch sensitive target comprising a subsegmentation into an asymmetric distribution of a plurality of etch-sensitive and etch-insensitive proxy structures; and
- Figure 12 depicts a schematic representation of an example two-layer etch sensitive target.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

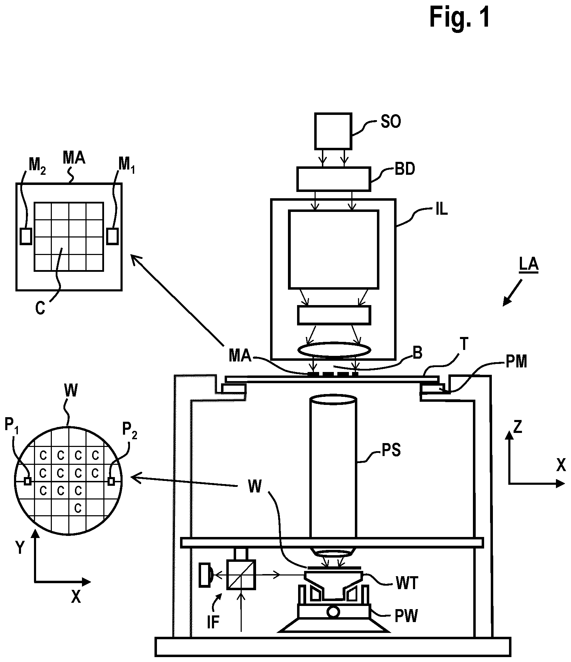

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

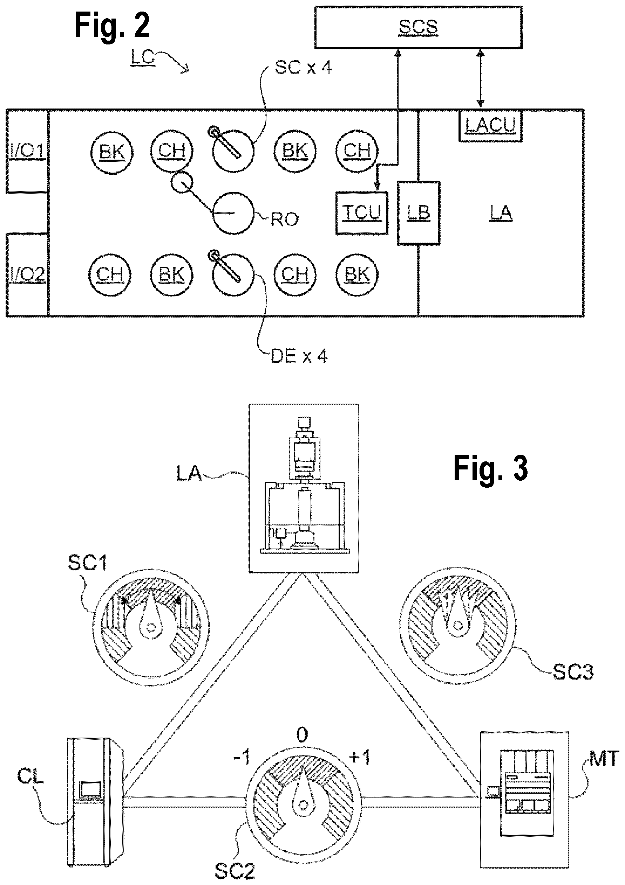

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

The lithographic apparatus LA and radiation source SO described herein can be used in a method for manufacturing a semiconductor device. A semiconductor device manufacturing method comprises receiving a substrate W with a resist, e.g. photoresist layer. The method further comprises directing a radiation beam from radiation source SO to transfer a pattern from a mask onto the photoresist layer. This could be achieved by a patterning device which is configured to form a patterned radiation beam, imparting the patterned radiation beam onto the photoresist layer. The method for manufacturing a semiconductor device further comprises the step of removing a portion of the photoresist layer to form the pattern over the substrate W.

The substrate W may be made of silicon or other semiconductor materials. Alternatively or additionally, the substrate W may include other semiconductor materials such as germanium (Ge) or carbon (C). In some embodiments, the semiconductor substrate is made of a compound semiconductor such as III-V compound semiconductors, II-V compound semiconductors, and/or any suitable integration of Group IV materials. In some embodiments, the substrate W may be a silicon-on-insulator (SOI) or a germanium-on-insulator (GOI) substrate.

The semiconductor device made from the substrate W may have various device elements. Examples of semiconductor device elements that are formed over the substrate W include transistors (e.g., planar or non-planar metal oxide semiconductor field effect transistors (MOSFET), bipolar junction transistors (BJT), high-voltage transistors, high-frequency transistors, etc.), diodes, CMOS image sensors, passive devices, and/or other applicable elements. Various processes may be performed to form the semiconductor device elements, such as deposition, etching, implantation, epitaxial growth, polishing, thermal treatment, and/or other suitable processes. In some embodiments, the substrate W is coated with a photoresist layer sensitive to the EUV or DUV radiation.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

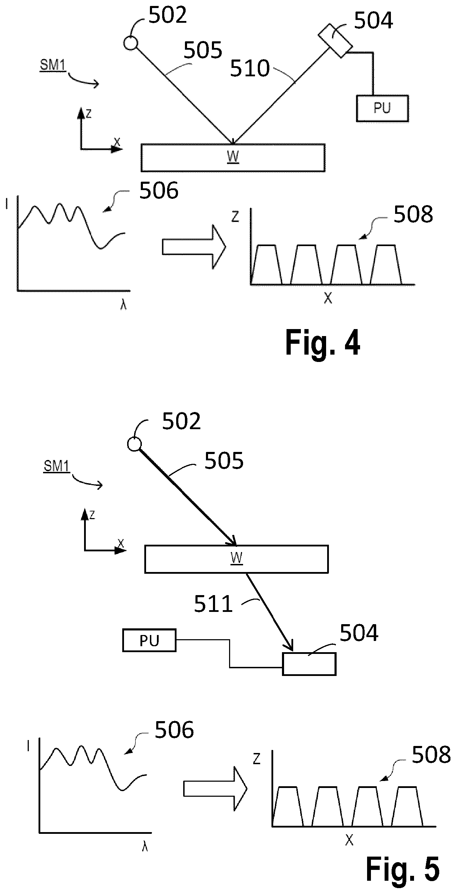

One example of a metrology apparatus, such as a scatterometer, is depicted in Figure 4. It may comprise a broadband (e.g. white light) radiation projector 502 which projects radiation 505 onto a substrate W. The reflected or scattered radiation 510 is passed to a spectrometer detector 504, which measures a spectrum 506 (i.e. a measurement of intensity I as a function of wavelength λ) of the specular reflected radiation. From this data, the structure or profile 508 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 511 is passed to a spectrometer detector 504, which measures a spectrum 506 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

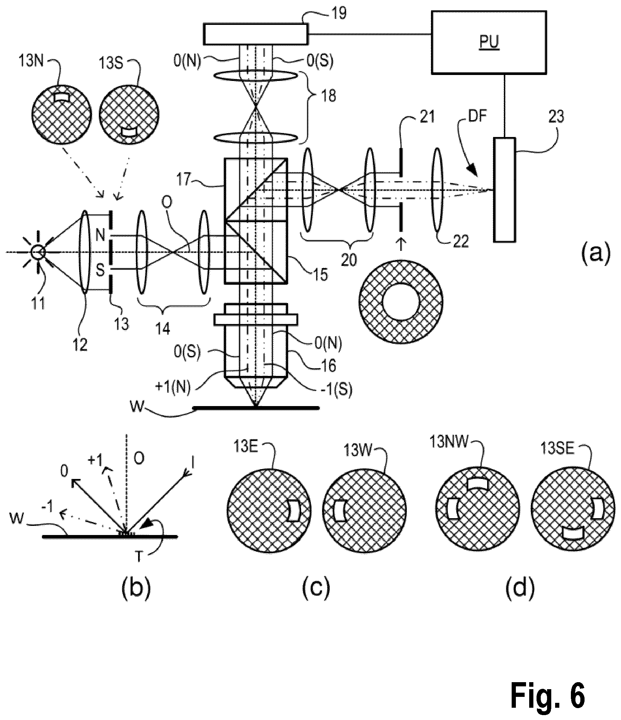

Figure 6(a) presents an embodiment of a metrology apparatus and, more specifically, a dark field scatterometer. A target T and diffracted rays of measurement radiation used to illuminate the target are illustrated in more detail in Figure 6(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 6(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 6(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 6(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 6 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 6) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 6(c) and (d). The use of these, and numerous other variations and applications of the apparatus are described in prior published applications, mentioned above.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+ 1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

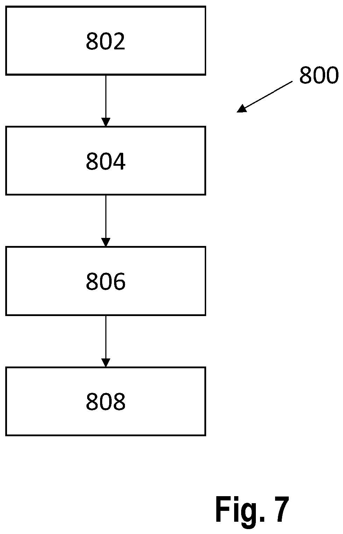

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

Different types of measurement can be used to determine characteristics and properties of the lithographically patterned structure. The type(s) of measurement suitable to be used may depend on the parameter(s) to be measured, as well as the properties of the patterned structures. Properties of the patterned structure may include materials used (refractive index, dielectric constant, nonlinear response, etc.), dimensions, periodicity defects, irregularities, etc. As the size of lithographically patterned structures has reduced over time, the designs of the structures forming lithographically patterned devices have also scaled down and changed. For example, as scaling of semiconductor structures have reduced beyond a 5 nm resolution, new logic designs may be used, such as vertically stacked designs. An example of a vertically stacked small-scale structure is a Gate-All-Around transistor, which may be formed for example of stacked nanosheets. Producing the new designs may require new fabrication steps and/or new properties to be measured. One such example is a lateral etch direction and associated lateral etch depth. A lateral etching step may be critical for the successful functioning of devices. Therefore, it is desirable to be able to accurately and precisely measure the lateral etch depth.

The layers of a patterned semiconductor substrate may be described as horizontal, or horizontally planar. Structures may be patterned in horizontally planar materials layered on top of each other. For example, a patterning mask may be provided in a horizontal plane, and the subsequent exposure and/or etching steps may be performed from the top down through one or more layers. This may be referred to as a vertical direction, substantially perpendicular to the horizontal layer(s). While etching processes may be anisotropic or uniform in all directions, it is possible to obtain a directional etching step, such as lateral, or diagonal. A lateral direction for an etch or exposure (i.e. along the horizontal direction) may be used for example in novel pattern designs such as gate all around (GAA) transistors.

Quantifying a lateral etching step may require metrology methods that are different from the usual inspection and metrology tools used for horizontally planar semiconductor designs. Example methods are known that are able to measure a lateral structure, including Scanning Electron Microscopy (SEM), Transmission Electron Microscopy (TEM), Optical Critical Dimension OCD, X-Ray Fluorescence (XRF), and Critical Dimension Small Angle X-Ray Scattering (CDSAXS). However, these methods may all have associated disadvantages such as computational cost, slow/long measurement times, potentially destructive effects on the patterned structures, and being incompatible to be used inline with other metrology systems in a semiconductor fabrication and metrology process. TEM may be destructive to the substrate and sample preparation and measurement may be time intensive. SEM, CDSAXS, and XRF may be slow and not suitable for inline metrology. OCD may be susceptible to crosstalk and therefore challenging to obtain accurate and precise results. They may therefore not be suitable for high volume manufacturing applications. Proposed herein and methods, systems, and targets to overcome some of the challenges and disadvantages associated with known methods for quantifying lateral features such as etch depth. While the measurement methods disclosed herein are described in relation to a lateral etch, it will be understood that they can be used for other applications such a material deposition in the lateral direction.

Figure 7 depicts a flow chart of a method 800 for measuring an etch depth of a structure on a substrate. The etch depth may be a lateral etch depth. The method comprises providing 802 a substrate comprising the structure and an etch sensitive target, wherein the etch sensitive target is configured to have an asymmetric response to the etch. Performing 804 an etch of the substrate, wherein the etch affects an asymmetry in the etch sensitive target by adding to the asymmetry of the target by etching away some material. The etch sensitive target is measured 806 to quantify the asymmetry. The measurement is performed using radiation, such as electromagnetic radiation. The quantified asymmetry is mapped 808 to an etch depth, wherein the mapping is based on predetermined etch reference values. The predetermined etch reference values may have been determined by prior reference measurements for the etch sensitive target using a reference measurement method. Note that step 808 is optional.

An advantage of the method 800 is that it enables measurement of an etch depth in any direction by translating it to an asymmetry measurement. The direction of the etch may be a lateral direction. The measurement may be performed using inline metrology tools. The measurement may be performed using electromagnetic radiation. The metrology tool may for example be the same tool that is used for measuring other parameters. The metrology tool may measure radiation scattered, optionally diffracted by the etch sensitive target. Having an asymmetric response may also decouple the response from symmetric parameter responses and/or reduce cross-talk to such parameters. As a result, the noise introduced to an asymmetric measurement may be reduced compared to if the response was symmetric.

The method 800 may be agnostic to the etch direction. Depending on the direction of the asymmetry present in the etch sensitive target, this method may be used to detect vertical, horizontal, and/or diagonal etching directions. The examples described in more detail herein will focus on a lateral etch direction.

The etch sensitive target may comprise a structure to be measured. The structure may comprise a diffraction structure, such as for example diffraction grating. A diffraction grating may be a two-dimensional diffraction grating, such as line grating. These lines may be referred to as diffraction elements A traditional line grating may comprise a plurality of elongated, substantially rectangular structures which may be periodically spaced apart. Radiation incident on a grating may be diffracted into a plurality of diffraction orders, including as zeroth order, positive +1 and negative -1 first diffraction orders, positive and negative higher diffraction orders, etc. An asymmetrical etch-sensitivity may be introduced in a target for example through subsegmentation and/or selective etching of the structures of the target. Subsegmentation may comprise taking diffraction elements on the target and segmenting it into multiple substructures which may be asymmetric and/or have an asymmetric distribution in the subsegmentation. In selective etching, some of the substrate to structures may be sensitive to etching, while others are insensitive to etching. By distributing these sensitive and insensitive structures asymmetrically, an asymmetry may be introduced through etching.

In a symmetric grating structure, the positive and negative diffraction orders may have the same intensity. An introduced asymmetry may be measured for example in an intensity difference between a positive first +1 diffraction order and a negative first -1 diffraction order and an example of the measurement is described in WO2010076232A2, incorporated herein by reference in its entirety. An asymmetry introduced by etching may therefore be measured for example by measuring radiation of a plurality of non-zero diffraction orders, and comparing their intensities. In an example, an asymmetry measurement may comprise comparing the positive first +1 and negative first -1 diffraction orders, and/or positive and negative higher order diffraction orders. An introduced asymmetry may also be measured for example in an intensity asymmetry of a measured pupil plane of the metrology system using machine learning algorithm and an example of the measurement method is described in US12142535B2, incorporated herein by reference in its entirety.

The etch sensitive target may be patterned in a single layer of the substrate. A single layer in this context may comprise multiple layers of material which may combine together to form a single grating layer having a functioning structure (e.g. an etch sensitive target). The single device layer may also be referred to as a device plane. That is to say, an etch sensitive target in a single layer may allow the measurement to be performed on a target structure without requiring a reference structure in a layer above or below. The etch sensitive target itself may comprise multiple layers of materials and/or patterning to form the structures of the target device (e.g. multiple layers of alternating materials stacked on top of each other).

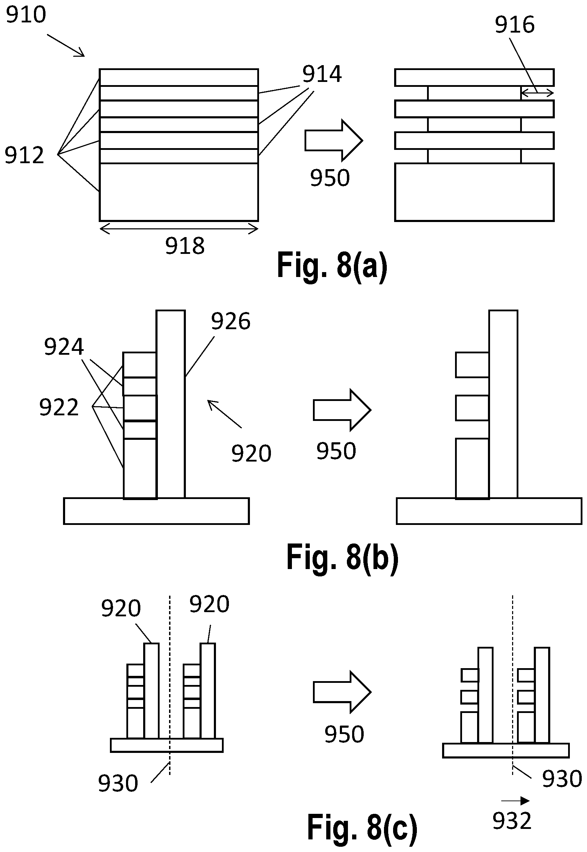

Figure 8 depicts schematic representations of structures that have a sensitivity to lateral etching. In figure 8(a) a proxy structure 910 is shown comprising alternating layers of a first material 912 and a second material 914, wherein the first and second materials may have a different sensitivity to an etching process 950 to be performed on the proxy structure. The materials may for example comprise silicon Si and silicon germanium SiGe, wherein silicon germanium SiGe is etched (e.g. plasma etch), while silicon is substantially not etched. The etch may be a selective etch in which one material (e.g. SiGe) is etched while another (e.g. Si) is not. The etch may be a wet etch, a dry etch, or a combination of both. The duration of the etch may affect the amount of material that is etched away, which may also be referred to as an etch depth 916. As the silicon germanium is only exposed from the sides of the proxy structure 910, the etch depth 916 may be the same or similar regardless of width 918 of the proxy structure. Therefore, an asymmetry may be introduced for example by providing a plurality of proxy structures 910 each having a different width 918, and etching all of them the same amount to have the same or similar etch depth 916.

Figure 8(b) depicts an example proxy structure having an asymmetrically designed structure with alternating layers in a vertical direction 920 (e.g. an asymmetrically designed forksheet structure). In this example design one side of the structure comprises a set of layers of alternating first 922 and second 924 materials, wherein the first and second materials have a different etch sensitivity to an etching process to be applied to the structure. For example, the first material 922 (e.g. Si) may be insensitive to the etch, while the second material 924 (e.g. SiGe) may be sensitive to the etch. The other side of the structure may have a third material 926 that is insensitive to the etching process (e.g. the same material to the first material 922 or different material such as SiO₂). During an etching step 950 the second material 924 may be fully or partially etched away, wherein the duration of etch may determine the etch depth. As illustrated in figure 8(b), the nature of the etch may be asymmetric, meaning the effect of the etch may result in an asymmetry introduced in the optical response of the forksheet proxy structure. Figure 8(c) illustrates an example in which two proxy forksheet structures 920 are provided next to each other as part of a target structure. In a real target structure more than two proxy forksheet structures 920 may be provided. Before etching, an optical centre of mass, represented by line 930 may be positioned in a first location between the two proxy structures 920. After the etching step 950 which removes material asymmetrically, from one side of the proxy structure, the optical centre of mass 930 may have shifted 932 to the right (arrow is for illustration purposes only and not representative of the amount of shift) to the second location.

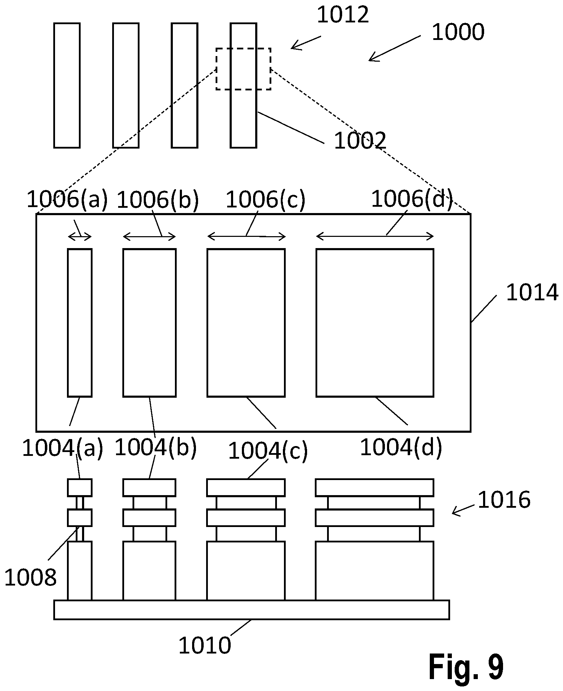

Figure 9 depicts an example target 1000 that has an asymmetric sensitivity to a lateral etch. The etch sensitive target may comprise a diffraction grating 1000 formed from a plurality of diffraction elements, such as grating lines 1002. Each diffraction element 1002 may be subsegmented into a plurality segments which may comprise a plurality of nanosheet structures 1004(a), 1004(b), 1004(c), 1004(d) which may be printed on a substrate 1010 to form an asymmetric subsegmentation. Nanosheet structures are optional. The asymmetry may be introduced for example by providing nanosheet structures with different widths 1006(a), 1006(b), 1006(c), 1006(d). Views 1012 and 1014 both depict top views of portions of the target structure. The nano sheet structures may comprise a plurality of alternating horizontal layers

View 1016 depicts a side-on (in-plane) view of the single layer of the substrate in which the proxy structures 1004(a)-(d) are present. The etch depth 1008 may be the same or similar for each of the proxy structures. The ratio of the etch depth 1008 to the different widths 1006(a)-(d) of the proxy structures may therefore be different. It may introduce a gradient in the refractive index of the subsegmented diffraction element 1002. This gradient index may introduce an asymmetry in the response of the diffraction grating. The etch depth may determine the amount of change to the asymmetry, and therefore measured asymmetry may be used to determine etch depth.

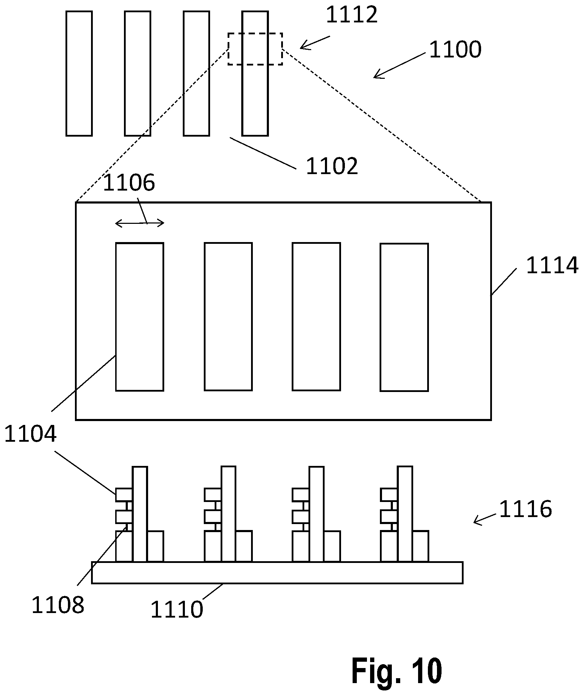

Figure 10 depicts an example target 1100 that has an asymmetric sensitivity to a lateral etch. The etch sensitive target may comprise diffraction grating 1100 formed from a plurality of diffraction grating lines 1102. Each diffraction grating line 1102 may be subsegmented into a plurality of proxy structures 1104 which may be formed on a substrate 1110. The proxy structures 1104 may be asymmetrical forksheet structures. The etch time may be linked to an etch depth 1108, which is linked to an amount of asymmetry added to the proxy structures. A greater etch depth may move the optical centre of mass of the proxy structure by a greater amount. The resulting effect on the asymmetric response of the target may be increased as etch depth increases. 1112 and 1114 both depict top views of portions of the target structure. 1116 depicts a side-on (in-plane) view of the (single) layer in which the proxy structures are present.

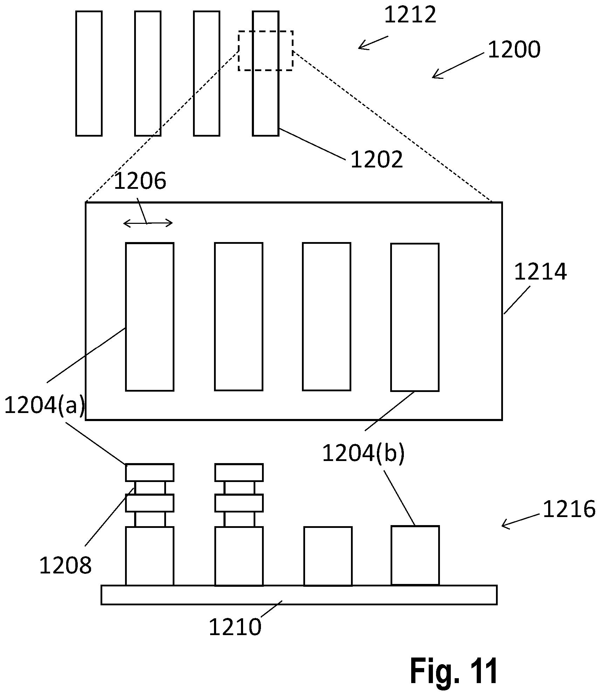

Figure 11 depicts an example target 1200 that has an asymmetric sensitivity to a lateral etch. The etch sensitive target may comprise diffraction grating 1200 formed from a plurality of diffraction grating lines 1202. Each diffraction grating line 1202 may be subsegmented into a plurality of proxy structures 1204(a) and 1204(b) which may be formed on a substrate 1210. The proxy structures 1204(a) may be structures that are sensitive to a lateral etch, for example nanosheet structures (depicted), asymmetrical forksheet structures, or gate all around structures. The proxy structures 1204(b) may be dummy structures which are insensitive, or less sensitive than 1204(a), to a lateral etch. Each grating line may be subsegmented to comprise at least some etch-sensitive proxy structures 1204(a) and at least some proxy structures 1204(b) insensitive, or less sensitive than 1204(a), to the etching process. The subsegmentation may comprise for example half of each type of proxy structure, or another proportion of etch-sensitive 1204(a) and etch-insensitive 1204(b) proxy structures. The etch-sensitive proxy structures 1204(a) may be grouped on one side of the subsegmented grating line, and the etch-insensitive dummy structures 1204(b) may be grouped on the other side of the grating line. This may create a diffractive index difference between the two groups, which may approximate a diffractive index gradient for the subsegmented diffraction element. This may lead to an asymmetric response for the diffraction grating wherein the amount of asymmetry is linked to the etch depth of the proxy structures 1204(a).

The etch time may be linked to an etch depth 1108 of the proxy structures 1204(a) while not affecting dummy structures 1204(b). The etch time is therefore linked to an amount of asymmetry added to the proxy structures. A greater etch depth may move the optical centre of mass of the proxy structure by a greater amount. The resulting effect on the asymmetric response of the target may be increased as etch depth increases. Views 1212 and 1214 both depict top views of portions of the target structure. 1216 depicts a side-on (in-plane) view of the (single) layer in which the proxy structures are present.

The examples of lateral etch sensitive targets described in relation to figures 9, 10, and 11 are provided as examples only, and the methods described herein may work for any proxy structure design that introduces etch sensitive asymmetry. The proxy structures may be designed to approximate or possess at least some design characteristics of device structures, such as gate all around GAA structures, Multi-Bridge Channel FET structures, Nanosheet structures, RibbonFET structures, 3D-NAND structures, DRAM structures (e.g. 3DDRAM, x-DRAM, 6F2 DRAM, 4F2 DRAM), forksheet structures, complementary FET structures, finFET structures, or other structures to be patterned on the substrate.

As described above, the asymmetry measurement may rely on the change of the optical centre of mass introduced by the asymmetric response to the etch. The asymmetry present in the etch target may not be solely linked to etch depth. Other features affecting asymmetry may also be present in the target, either introduced intentionally and/or as a result of process errors. Therefore, the correct interpretation of the asymmetric response signal may depend on the correlation of other asymmetry introducing defects. This may be performed for example through calibration of the target, measurement of other parameters, and/or computation based on the measured data, such as a training algorithm (e.g. a machine learning algorithm) to support interpretation of the measured data. Using calibration and/or algorithmic training may improve determination of the correlation between asymmetry introduced by the etching process, and process variations.

The relationship between a measured asymmetry to an etch depth may be specific to a target design. In order to determine the relationship for a specific target design, that design may be calibrated using a reference method. That is to say, an asymmetry of the target may be measured for a plurality of different etch durations, and the etch depth may be measured using a reference method. These calibrated etch depths may be stored as etch reference values with their associated measured asymmetry. The reference metrology method may be any known method for measuring (lateral) etch depth (e.g. Soft X-Ray metrology, TEM, CDSAXS, SEM, XRF, etc). Concerns regarding time, cost, or potential destructive effects on the structure are of less importance for a calibration step, as the measurement is not performed for each substrate. In an example calibration process, etch depth may be measured for a plurality of etch amounts using the reference measurement method. The measured etch depth is saved as an etch reference value. For that etch amount, the asymmetry of the reference etch sensitive target is also measured using the asymmetry measurement method to be calibrated. The measured asymmetry may be associated and stored with the etch reference value.

In some implementations, the etch-sensitive target may be measured using Soft X-Ray radiation, for example using one or more wavelengths in a range of 0.1 nm to 100 nm, or optionally 1 nm to 20 nm. This short wavelength radiation may measure etch depth information for one or more individual layers of a substrate. Another advantage is that different parameters of interest are less correlated using wavelengths in the range of 1 nm to 20 nm. The etch depth information for one or more individual layers may be inferred via model-based reconstruction, and an example of the method is described in WO2023232478A1, incorporated herein by reference in its entirety.

The examples described above use etch sensitive targets formed in a single layer, in which the target is measured and analysed without comparison to another layer on the substrate. The single layer may comprise multiple layers of material, and may therefore also be referred to as a single device plane. In some alternative implementations, the measurement may comprise obtaining information from two or more vertically stacked layers on the substrate, and a comparison of one layer relative to the other(s). An etch sensitive target may for example comprise two vertically stacked layers. The etch may be a lateral etch and the etch sensitive target may be a lateral etch sensitive target comprising etch sensitive structures in at least one of the vertically stacked layers. The measurement may comprise obtaining an overlay measurement of radiation scattered, e.g. diffracted, by the two vertically stacked layers. In one embodiment, the targets of the two vertically stacked layers have the same pitch. In another embodiment, the targets of the two vertically stacked layers have different pitches.

A lateral etch sensitive target may comprise two vertically stacked layers, wherein the first layer may comprise etch sensitive structures, and wherein the second layer may comprise structures that are insensitive to the etch. Both layers may comprise a diffracting structure, such as a diffraction grating, wherein the diffraction grating is formed from a plurality of diffraction elements. The diffraction grating may for example be a line grating, wherein each line may be a diffraction element. Each diffraction element may be subsegmented into a plurality of proxy structures. In an example implementation, provided for illustration purposes only and not to be interpreted as limiting, a diffraction grating may be provided with the periodicity of 800 nm, with a grating line (diffraction element) having a width of 400 nm. Each 400 nm diffraction element may be subsegmented into 4 proxy structures, wherein the periodicity of the proxy structures may be 100 nm.

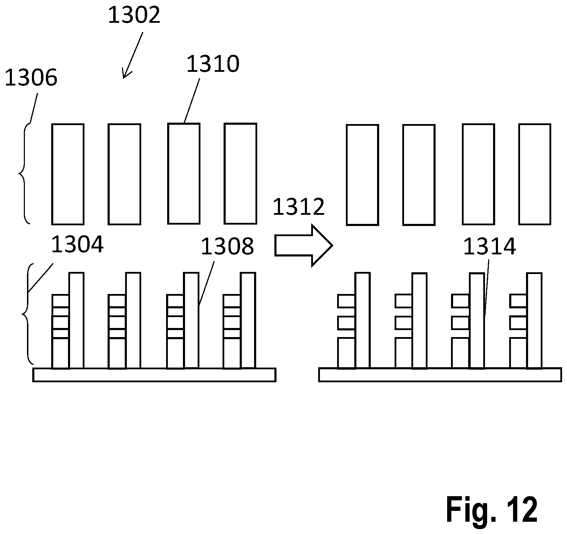

Figure 12 depicts a schematic representation of a side-on view of a portion of an example diffraction element. The view depicts both layers of a two-layer target 1302, comprising a first layer 1304 and a second layer 1306. The second layer 1306 may be a resist layer. The first layer 1304 may be an etch sensitive layer, wherein the etch is configured to add an asymmetry to the layer. The first layer 1304 may be formed from etch sensitive structures which may be referred to as proxy structures 1308. A proxy structure 1308 may have a design for example as described in relation to a single layer etch sensitive target above. The example depicted in figure 12 may be a forksheet structure. The asymmetry of the structures 1308 may result in an etch 1312 shifting an optical centre of mass between the un-etched proxy structure 1308 and the etched proxy structure 1314. The amount of asymmetry added to the target by the etch may be a measure for the depth of the image.

The second layer 1306 of the two layer target may comprise a subsegmented diffraction element with a plurality of dummy structures 1310. The dummy structures 1310 may be insensitive to the etching process, and may have symmetric properties. The dummy structures 1310 may have a periodicity that matches the periodicity of the proxy structures 1308 in the first layer 1304. The dummy structures may be used as a reference layer, for example for an overlay measurement. The etch sensitive layer may be formed in a bottom layer of the target.

A two layer grating as described herein may be sensitive to a lateral etch. It may translate the lateral etch into a measurable asymmetry response, such as an overlay response. The two layer grating may for example comprise a diffraction grating that has been subsegmented. The segments may comprise a proxy structure that partially reproduces features of a device of interest and/or possesses some of the relevant properties of this device. One of the two layers may comprise a proxy structure, the other may comprise a reference structure. The reference structure may be a reference grating that is not subsegmented. A proxy structure may mimic one or more device features of interest to such an extent that the lateral etch response of the proxy structure is the same as the lateral etch response of the actual device structure. This may for example include having a same or similar geometry, and/or a same or similar chemical composition as the actual device structure. The proxy structure does not need to possess the functionality of the device. Properties other than those affected a lateral etch response (e.g. electronic properties) do not need to match the actual device structure.

An advantage of using overlay metrology for measuring an asymmetry associated with a lateral etch depth may be that overlay measurements are already performed on patterned substrates. As a result standard overlay targets may also be present on the substrate, for example for measuring overlay and/or other properties of the substrate. A standard overlay target may comprise a grating structure (e.g. lines) in two different layers, it may have a deliberate offset introduced between the grating structures of the two layers, a grating pitch that matches the dimensions of interest. An overlay target may have a size and footprint that is compatible with the apparatus used to measure the target. An overlay target may for example comprise two pairs of gratings in two different layers. The pairs of gratings may be biased in opposite directions. The intensity of the individual diffraction orders from the target may represent a measure of overlay. The same overlay metrology setup may be used to measure both an overlay target, as well as a lateral etch sensitive target. The standard overlay target may be referred to in this context as a reference target. In an example application, a standard overlay target which is not sensitive to etching may be measured, to correct for actual overlay. The lateral etch sensitive target may also be measured using the same metrology setup. The measurement of the standard overlay target may be used as a reference, for example to correct for any real overlay errors present in both patterned structures. For increased robustness, the reference target and the lateral etch sensitive target may be positioned in close proximity to each other on the substrate. Close proximity may be for example be as close as having 20 µm between the two targets. Due to their close proximity it may be assumed that the overlay error is constant between the two targets, allowing to subtract the overlay values determined from the reference target from the overlay values measured for the lateral etch sensitive target, which may enable it to isolate the effects of the asymmetry inducing etch.

In some etch sensitive target designs, each of the proxy structures may have the same etch-sensitive asymmetry (e.g. as depicted for a single layer target in figure 10). In some other target designs, different proxy structures having different asymmetry sensitivities may be used. In some target designs, each proxy structure has its own asymmetry, for example as shows in the asymmetric forksheet structures of figure 10. In other target designs, the proxy structure may have a symmetric design, and an asymmetry may be introduced by providing a plurality of proxy structures having differing designs (e.g. as shown in figure 9), or by providing an asymmetric combination of etch-sensitive and etch-insensitive proxy structures (as depicted in figure 11).

The measurements described herein may be performed using electromagnetic radiation, such as visible, infrared radiation, and/or ultraviolet radiation. The radiation may for example comprise one or more wavelengths in a range of 100 nm to 2000 nm, or one or more wavelengths in a range of 300 nm to 900 nm. In some alternative implementations, shorter radiation, such as Deep ultraviolet DUV , Extreme ultraviolet EUV, or Soft-X-Ray radiation may be used in the method above, to obtain etch depth information.

The measurement may be obtained by a detector in an exit pupil plane of the metrology tool. In some implementations, one or more beam splitters or other optical components may be used to direct some of the diffracted radiation into one or more separate branch directions. One or more apertures may for example be placed in a pupil plane to select the diffraction order(s) of interest. Further lenses and/or other optical elements may be used to direct radiation to a detector in an image plane for detecting radiation. Radiation can additional or alternatively be detected in a conjugate plane of an exit pupil or image plane. The introduced asymmetry may be measured for example in an intensity asymmetry of the pupil plane, optionally using machine learning algorithm, and an example of the measurement method is described in US12142535B2, incorporated herein by reference in its entirety.

The material to be etched may be silicon germanium SiGe configured to be at least partially etched away during an etching process. Etch-sensitive materials to be removed during a (lateral) etch may alternatively or additionally include one or more of an oxide of silicon (SiOₓ), a nitride of silicon (SiₓN_{y}), or a silicon oxynitride (SiₓO_{y}N_{z}), configured to be at least partially removed during an etch. Example materials used in a semiconductor patterning structures that are insensitive to a (lateral) etching process to be used may include silicon and silicon dioxide (SiO₂). Depending on the type of etch, a material may either be more or less sensitive, or insensitive to an etching process (e.g. SiO₂)

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. A method for measuring an etch depth of a structure on a substrate, the method comprising:
   providing the substrate comprising the structure and a etch-sensitive target configured to have an asymmetric response to a etch;
   performing the etch of the substrate, thereby affecting an asymmetry in the etch-sensitive target;
   measuring, using radiation, the etch-sensitive target to quantify the asymmetry; and
   mapping the quantified asymmetry to the etch depth based on predetermined etch reference values.
2. A method according to clause 1, wherein the etch-sensitive target is patterned in a single layer in the substrate.
3. A method according to clause 1 or 2, wherein the etch is a lateral etch, and wherein the etch-sensitive target is a lateral-etch sensitive target.
4. A method according to any of the preceding clauses, wherein the measuring comprises measuring radiation diffracted by the asymmetric etch-sensitive target.
5. A method according to clause 4, wherein measuring the etch-sensitive target to quantify the asymmetry comprises determining an intensity difference between a positive diffraction order and negative diffraction order.
6. A method according to any of the preceding clauses, wherein the measuring is performed in an exit pupil plane of a metrology tool, or in an image plane of a metrology tool.
7. A method according to any of the preceding clauses, wherein the wavelength of the radiation comprises one or more wavelengths in a range of 100 nm - 2000 nm, or one or more wavelengths in a range of 300 nm to 900 nm.
8. A method according to any of the preceding clauses, wherein the target comprises a subsegmented diffraction arrangement comprising a plurality of diffraction elements, wherein each diffraction element is segmented into a plurality of proxy structures.
9. A method according to clause 8, wherein the diffraction arrangement is a diffraction grating, and wherein the plurality of diffraction elements comprise a plurality of grating lines.
10. A method according to any of clauses 8-9, wherein at least some of the plurality of proxy structures comprise alternating horizontal layers.
11. A method according to any of clauses 8 - 10, wherein at least some of the plurality of proxy structures comprise one or more of a nanosheet structure, a forksheet structure, or a gate all around structure.
12. A method according to any of clauses 8 - 11, wherein at least some of the plurality of proxy structures comprise a DRAM structure, or a 3DNAND structure.
13. A method according to any of clauses 8 - 12, wherein at least some of the plurality of proxy structures comprise an asymmetric etch sensitivity.
14. A method according to any of clauses 8 - 13, wherein each proxy structure of the plurality of proxy structures comprises the same asymmetric etch sensitivity.
15. A method according to any of the preceding clauses, wherein one or more of the plurality of proxy structures comprise an asymmetric etch sensitivity, and the other of the plurality of proxy structures are insensitive to an etch.
16. A method according to any of the preceding clauses, wherein the measuring comprises using soft-X-ray radiation to obtain etch depth information.
17. A method according to clause 16, wherein the measuring comprises obtaining etch depth information for one or more individual layers on the substrate.
18. A method according to clause 1, wherein the target is patterned in two vertically stacked layers.
19. A method according to clause 18, wherein the etch is a lateral etch, and wherein the etch-sensitive target is a lateral-etch sensitive target.
20. A method according to any of clauses 18 - 19, wherein the measuring comprises obtaining an overlay measurement of radiation diffracted by the target.
21. A method according to clause 20, wherein the wavelength of the radiation comprises one or more wavelengths in a range of 100 nm - 2000 nm.
22. A method according to any of clauses 18 - 21, wherein a first layer of the two vertically stacked layers of the target comprises a plurality of proxy structures configured to introduce an asymmetry as a function of the amount of etch.
23. A method according to clause 22, wherein each proxy structure of the first layer comprises the same asymmetry introducing proxy structure.
24. A method according to clause 22 or 23, wherein one or more of the plurality of proxy structures comprise an asymmetry introducing proxy structure, and the others of the plurality of proxy structures comprise a dummy structure that is insensitive to an etch.
25. A method according to any of the preceding clauses, wherein the etch reference values have been determined using a reference measurement method.
26. A method according to clause 25, wherein the reference measurement method is one of: a Transmission Electron Microscopy TEM measurement, a Scanning Electron Microscopy SEM measurement, a Soft X-Ray SXR measurement, a Critical Dimension Small Angle X-Ray Scattering measurement CDSAXS, or X-Ray Fluorescence XRF measurement.
27. A method according to any of clauses 25 - 26, wherein the etch reference values have been determined by, for each etch amount of a plurality of etch amounts:
   measuring, using the reference measurement method, the etch depth on a reference structure for the etch amount, and adding the measured etch depth as an etch reference value;
   measuring the asymmetry of a reference etch-sensitive target for the etch amount; and
   associating the measured asymmetry to the etch reference value.
28. A method according to any of the preceding clauses, wherein the etch sensitive target and the structure comprise silicon germanium SiGe configured to be at least partially removed during the etch.
29. A method according to any of the preceding clauses, wherein the etch-sensitive target and the structure comprise one or more of an oxide of silicon SiOₓ, a nitride of silicon SiₓN_{y}, or a silicon oxynitride SiₓO_{y}N_{z}, configured to be at least partially removed during the etch.
30. A target on a substrate for measurement of a etch depth of a structure on a substrate, the target comprising:
   a first layer on the substrate comprising a subsegmented diffraction arrangement comprising a plurality of diffraction elements, wherein each diffraction element comprises a plurality of proxy structures; and
   wherein one or more of the plurality of proxy structures comprise an asymmetrical etch sensitivity.
31. A target according to clause 30, wherein the target is patterned in a single layer of the substrate.
32. A target according to clause 30, wherein the target comprises a second layer on the substrate, and wherein the measurement of the etch depth of the structure is an overlay measurement.
33. An apparatus configured to perform a method of any of clauses 1 - 29.
34. An exposure apparatus for a semiconductor manufacturing process configured to perform a method according to any of clauses 1 - 29.
35. An metrology apparatus configured to perform a method according to any of clauses 1 - 29.
36. An inspection apparatus configured to perform a method according to any of clauses 1 - 29.
37. A lithography apparatus configured to perform a method according to any of clauses 1 - 29.
38. A litho cell comprising an apparatus according to any of clauses 34 - 37.
39. A substrate comprising a target of any of claims 30 - 32.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.
Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method for measuring an etch depth of a structure on a substrate, the method comprising:
providing the substrate comprising the structure and a etch-sensitive target configured to have an asymmetric response to a etch;
performing the etch of the substrate, thereby affecting an asymmetry in the etch-sensitive target;
measuring, using radiation, the etch-sensitive target to quantify the asymmetry; and
mapping the quantified asymmetry to the etch depth based on predetermined etch reference values.

2. A method according to claim 1, wherein the etch is a lateral etch, and wherein the etch-sensitive target is a lateral-etch sensitive target.

3. A method according to claim 1 or 2, wherein the measuring comprises measuring radiation diffracted by the etch-sensitive target.

4. A method according to claim 3, wherein measuring the etch-sensitive target to quantify the asymmetry comprises determining an intensity difference between a positive diffraction order and a negative diffraction order.

5. A method according to any of the preceding claims, wherein the target comprises a subsegmented diffraction arrangement comprising a plurality of diffraction elements, wherein each diffraction element is segmented into a plurality of proxy structures.

6. A method according to claim 5, wherein at least some of the plurality of proxy structures comprise alternating horizontal layers.

7. A method according to claim 5 or 6, wherein at least some of the plurality of proxy structures comprise an asymmetric etch sensitivity.

8. A method according to any of the preceding claims, wherein the measuring comprises using radiation with one or more wavelengths in a range of 1 nm to 20 nm to obtain etch depth information.

9. A method according to claim 8, wherein the measuring comprises obtaining etch depth information for one or more individual layers on the substrate.

10. A method according to any of the preceding claims, wherein the etch sensitive target and the structure comprise silicon germanium SiGe configured to be at least partially removed during the etch.

11. A target on a substrate for measurement of a etch depth of a structure on a substrate, the target comprising:
a first layer on the substrate comprising a subsegmented diffraction arrangement comprising a plurality of diffraction elements, wherein each diffraction element comprises a plurality of proxy structures; and
wherein one or more of the plurality of proxy structures comprise an asymmetrical etch sensitivity.

12. A target according to claim 11, wherein the target is patterned in a single layer of the substrate.

13. A target according to claim 11, wherein the target comprises a second layer on the substrate, and wherein the measurement of the etch depth of the structure is an overlay measurement.

14. A substrate comprising a target of any of claims 11 to 13.

15. An apparatus comprising a processor to perform the method of any of claims 1 to 10.
